# EUROPÄISCHE PATENTSCHRIFT

(11) **EP 1 232 294 B1**
(45) Veröffentlichungstag und Bekanntmachung des Hinweises auf die Patenterteilung: **26.01.2005**
(21) Anmeldenummer: 00972586.2
(22) Anmeldetag: 07.09.2000
(51) Int. Cl.: C23C 18/16

(54) **METALLISIERUNGSVERFAHREN FÜR DIELEKTRIKA**
METALLIZING METHOD FOR DIELECTRICS
PROCEDE DE METALLISATION DE DIELECTRIQUES

(30) Priorität: 26.11.1999 DE 19957130
(43) Veröffentlichungstag der Anmeldung: 21.08.2002
(73) Patentinhaber: Infineon Technologies AG, 81669 München (DE)
(72) Erfinder: SEZI, Recai, D-91341 Röttenbach (DE); SCHMID, Günter, D-91334 Hemhofen (DE); LOWACK, Klaus, D-91054 Erlangen (DE); RADLIK, Wolfgang, D-80993 München (DE); HAUSSMANN, Jörg, D-85354 Freising (DE)
(74) Vertreter: Kottmann, Heinz Dieter, Dipl.-Ing.
(86) Internationale Anmeldenummer: PCT/DE2000/003133
(87) Internationale Veröffentlichungsnummer: WO 2001/038603

(56) Entgegenhaltungen:
- DE-A- 19 851 101
- GB-A- 1 457 008

## Beschreibung

Die Erfindung betrifft ein Verfahren zur Metallisierung von Dielektrika.

In der Mikroelektronik werden metallische Leiter unter anderem durch chemische oder elektrochemische Abscheideverfahren hergestellt; der Trend geht dabei kontinuierlich in die Richtung von zuverlässigeren und kostengünstigeren Methoden. Die metallischen Leiterbahnen einer integrierten Schaltung (Integrated Circuit, IC) oder eines Multichip-Moduls (MCM) bestehen beispielsweise aus Kupfer. Die Isolierung der Leiterbahnen erfolgt mittels eines organischen oder anorganischen Dielektrikums, wie Polyimid bzw. Siliciumdioxid. Insbesondere für die sogenannte Umverdrahtung der äußeren Kontakte von ICs werden einfache und selektive Verfahren benötigt, um die Performance zu erhöhen und die Kosten zu senken. Die derzeit gebräuchlichen Verfahren sind meistens komplex und teuer, weil sie aus zahlreichen Einzelprozessen bestehen und teilweise auch kostspielige Vakuumprozesse beinhalten (siehe beispielsweise: H. Eigler, W. Beyer "Moderne Produktionsprozesse der Elektrotechnik, Elektronik und Mikrosystemtechnik: Entwurf - Optimierung - Technologietransfer", expert-Verlag, 1996, Seiten 304 bis 309).

So ist es beispielsweise bekannt, auf das Dielektrikum mittels eines Vakuumprozesses eine dünne Metallschicht aufzubringen, d.h. eine Galvanikstartschicht. Auf diese Metallschicht wird dann ein Photolack aufgeschleudert, belichtet und entwickelt. Durch die lithographische Strukturierung werden bestimmte Bereiche der Oberfläche freigelegt und die freigelegte Metalloberfläche wird anschließend galvanisch metallisiert. Nach dem Strippen des Photolacks wird die dünne Galvanikstartschicht geätzt (siehe beispielsweise: W. Menz, P. Bley "mikrosystemtechnik für Ingenieure", VCH Verlagsgesellschaft mbH, 1993, Seiten 192 bis 194, 198 bis 199 und 251).
Eine derartige Vorgehensweise ist jedoch aufwendig und kostenintensiv.

In GB 1 457 008 A wird ein Metallisierungsverfahren beschrieben, bei dem in einem polymeren synthetischen Harzsubstrat homogen Teilchen aus einem photosensitiven halbleitenden Metalloxid dispergiert sind. Hierbei werden zunächst die photosensitiven halbleitenden Metalloxidpartikel in dem synthetischen Polymerharz fein verteilt und diese Mischung auf das Substrat aufgetragen. Anschließend wird der aufgebrachte Polymerfilm verschiedenen Reinigungs- und Trocknungsprozeduren unterworfen.

Durch Belichtung über eine auf den Film positionierte Maske werden auf den belichteten Bereichen Metallkeime erzeugt. Das latente aus den Metallkeimen bestehende Abbild wird durch Kontaktierung mit einer metastabilen Metallsalzlösung und/oder durch elektrochemische Abscheidung weiter verstärkt.
Das erzeugte Muster aus leitfähigen Strukturen wird durch einen abschließenden Temperprozess stabilisiert.

Bei dem in GB 1 457 008 A beschriebenen Verfahren sind somit nur die Metalloxidpartikel photosensitiv, während das Polymerharz lediglich als Träger dient.

Aus der DE 198 51 101 A1 ist ein Verfahren zur selektiven Abscheidung einer Metallschicht auf der Oberfläche eines Kunststoffsubstrats bekannt. Dabei werden die zu beschichtenden Bereiche der Oberfläche mit elektromagnetischer Strahlung beaufschlagt, wobei chemische Bindungen gespalten und funktionelle Gruppen als reaktive Zentren geschaffen werden. Die Bestrahlung erfolgt insbesondere mit UV-Strahlung bei einer Wellenlänge < 320 nm, vorzugsweise 222 nm. Nach der Bestrahlung, die unter Zuhilfenahme einer Maske oder mittels eines schreibenden Laserstrahls erfolgt, wird an den reaktiven funktionellen Gruppen der Oberfläche eine Edelmetallverbindung fixiert. Dazu wird das Kunststoffteil entweder noch in eine Quell-Lösung getaucht, beispielsweise in eine 5-molare wäßrige NaOH-Lösung, oder unmittelbar mit einer die abzuscheidende Substanz enthaltenden Lösung, d.h. mit einer Keimlösung, kontaktiert. Nachfolgend wird in einem stromlosen Metallisierungsbad die Metallschicht abgeschieden.

Eine derartige Vorgehensweise ist in der Mikroelektronik nicht praktizierbar, da für die Spaltung der chemischen Bin-dungen energiereiche Strahlung, insbesondere der Wellenlänge von 222 nm, erforderlich ist. Es gibt aber keine ausreichend leistungsstarken Lampen dieser Wellenlänge, so daß die Belichtungszeiten deutlich höher liegen (Faktor > 10) als bei Standardbelichtungen. Dadurch wird aber der Durchsatz an bekeimbaren Substraten stark eingeschränkt und zudem sind die benötigten Excimer-UV-Lampen sehr teuer. Außerdem werden bei der Spaltung der Bindungen niedermolekulare Bruchstücke freigesetzt, welche die teuren Masken verschmutzen können. Ein Nachteil des bekannten Verfahrens ist ferner, daß es nur positiv arbeitet, d. h. nur die belichteten Bereich können bekeimt werden. Eine Arbeitsweise im negativen Modus, wobei die nicht-belichteten Bereiche bekeimt werden, ist dagegen nicht möglich. Dies kann dann hohe Zusatzkosten für neue Masken bedeuten, wenn beispielsweise für bereits existierende Prozesse nur Negativmasken erforderlich sind.

Aufgabe der Erfindung ist es, ein Verfahren bereitzustellen, das zur selektiven Metallisierung von Dielektrika geeignet ist und insbesondere in der Mikroelektronik eingesetzt werden kann, wobei das Erfordernis einer Kompatibilität mit den Gegebenheiten bestehender Prozeßlinien erfüllt sein muß.

Dies wird erfindungsgemäß dadurch erreicht, daß auf ein Substrat ein photoempfindliches Dielektrikum aufgebracht wird, und daß das Dielektrikum durch eine Maske belichtet, mit einem Metall bekeimt, einer Temperaturbehandlung unterworfen und dann chemisch metallisiert wird. Alternativ kann das Dielektrikum - nach dem Aufbringen auf das Substrat - zuerst mit einem Metall bekeimt und dann durch eine Maske belichtet werden; anschließend wird überschüssiges Bekeimungsmaterial entfernt und das Dielektrikum chemisch metallisiert.

Das Verfahren nach der Erfindung läuft somit in der Weise ab, daß zunächst ein photoempfindliches Dielektrikum auf ein Substrat aufgebracht wird. Vorzugsweise wird das Dielektrikum dabei in gelöster oder pastöser Form auf das Substrat aufgebracht, d.h. in mehr oder weniger flüssiger Phase, und dann wird getrocknet. Anschließend wird das Dielektrikum durch eine Maske belichtet und selektiv bekeimt. Unter "Bekeimen" wird dabei die Anbindung von Keimen an die Oberfläche und die chemische Aktivierung der Keime verstanden. Nachfolgend wird das Dielektrikum einer Temperaturbehandlung unterworfen, d.h. ausgeheizt, und chemisch metallisiert. Das Ausheizen erfolgt im allgemeinen bei einer Temperatur von 90 bis 450°C.

Bei einer alternativen Vorgehensweise wird zunächst auf der gesamten Oberfläche des Dielektrikums Bekeimungsmaterial adsorbiert; die selektive Verankerung und Aktivierung der Keime erfolgt dann mittels Belichtung durch eine Maske. Anschließend wird überschüssiges Bekeimungsmaterial entfernt und das Dielektrikum chemisch metallisiert. Das Entfernen des Bekeimungsmaterials erfolgt im allgemeinen durch Spülen mit Wasser oder mit einem Lösemittel.

Das Bekeimen (mit einem Metall) erfolgt in beiden Fällen vorzugsweise derart, daß das Dielektrikum mit einer metallhaltigen Keimlösung oder -emulsion behandelt wird. Das Dielektrikum kann beispielsweise aber auch einer keimhaltigen Atmosphäre einer leichtflüchtigen Metallverbindung ausgesetzt werden.

Als vorteilhaft hat es sich auch erwiesen, bei der Belichtung des Dielektrikums eine Maske mit engen Grabenund Lochstrukturen zu verwenden; hierbei werden nämlich besonders gute Resultate erzielt. Vorzugsweise weisen die Löcher einen Durchmesser von ca. 1 bis 3 µm auf, und der Abstand zwischen den Löchern beträgt ebenfalls ca. 1 bis 3 µm.

Das Dielektrikum besteht vorzugsweise aus einem Polymer und einer photoaktiven Komponente. Vorteilhaft kann aber auch ein Polymer eingesetzt werden, das selbst Photoempfindlichkeit besitzt, d.h. das Dielektrikum ist in diesem Fall ein photostrukturierbares Polymer. Das Polymer kann im übrigen auch ein Copolymer oder eine Polymermischung sein.

Das Polymer weist vorteilhaft eine hohe chemische und thermische Beständigkeit auf. Hierdurch werden Löt- und Reinigungsprozesse sowie die chemische Metallisierung unbeschadet überstanden. Das Polymer kann organischer oder anorganisch/organischer Natur sein. Vorteilhaft hat sich insbesondere der Einsatz folgender Arten von Polymeren erwiesen: Polyimide, Polybenzoxazole, Polybenzimidazole, vorwiegend aromatische Polyether, Polyetherketone und Polyethersulfone, Benzocyclobuten, Polychinoline, Polychinoxaline und Polysiloxane (Silicone). Copolymere oder Mischungen dieser Polymere untereinander sind ebenfalls geeignet.

Photostrukturierbare Polymere sind vielfach bekannt und auch kommerziell erhältlich. Beim Verfahren nach der Erfindung werden als Dielektrikum vorzugsweise folgende Polymere eingesetzt: positiv photostrukturierbare Polymere auf der Basis von Polybenzoxazolen (siehe beispielsweise: EP 0 023 662 B1 und EP 0 264 678 B1) und Polyimiden und negativ photostrukturierbare Polymere auf der Basis von Polyimiden (siehe beispielsweise: US-Patentschriften 3 957 512 und Re. 30 186).

Das Verfahren nach der Erfindung weist folgende wesentliche Vorteile auf:
- Die Belichtung kann, je nach der Zusammensetzung des Dielektrikums im nahen oder tiefen UV-Bereich erfolgen, d.h. zwischen 200 und 450 nm; der Bereich zwischen 350 und 450 nm ist besonders gut geeignet. Deshalb können kostengünstige Belichtungsgeräte verwendet werden, die in der Prozeßlinie bereits eingesetzt werden.
- Die Belichtungszeiten sind kurz, so daß ein guter Durchsatz gewährleistet ist.
- Je nach der Zusammensetzung des Dielektrikums können belichtete oder unbelichtete Bereiche selektiv bekeimt werden.
- Bei der Belichtung wird das Dielektrikum, d.h. das Polymer, an der Oberfläche nicht abgebaut bzw. ge spalten, so daß keine schädigenden niedermolekularen Produkte gebildet werden können.

Das Substrat besteht im allgemeinen aus Silizium oder keramischem Material, wobei es - unterhalb der dielektrischen Schicht - bereits elektronische Schaltungen, einschließlich Metall- und Isolierschichten, aufweisen kann. Das Substrat kann aber auch aus Glas oder Metall bestehen.

Das Dielektrikum kann in gelöster Form oder als Paste auf das Substrat aufgetragen werden. Geeignete Techniken sind dabei beispielsweise Schleudern, Gießen, Dispensen, Rakeln, Tampondrucken, Tintenstrahldrucken und Siebdrukken. Insbesondere bei der Verwendung als Paste sowie für das Siebdrucken, kön-nen dem Dielektrikum auch Füllstoffe zugegeben werden.

Das Bekeimen kann mittels metallhaltiger Keimlösungen oder -emulsionen erfolgen, beispielsweise durch Eintauchen des Dielektrikums. Die Keimlösungen bzw. -emulsionen enthalten dazu eine oder mehrere Metallverbindungen in ionogener oder kolloidaler Form. Die Keime sind dabei Materialien, welche die Abscheidung eines Metalls aus einer redoxchemisch metastabilen Lösung katalysieren. Als Keime eignen sich insbesondere Edelmetalle, wie Ruthenium (Ru), Rhodium (Rh), Palladium (Pd), Silber (Ag), Osmium (Os), Iridium (Ir), Platin (Pt) und Gold (Au), bzw. entsprechende Verbindungen und Komplexe (organischer und/oder anorganischer Natur). Derartige Verbindungen sind beispielsweise Palladiumverbindungen, wie Pd-Acetat und Pd-Chlorid.

Geeignete Komplexverbindungen sind insbesondere funktionalisierte cis-Diamino-di(pseudo)halogeno- oder -alkenyl-Komplexe von Pd(II)- oder Pt(II)-Verbindungen, da sie Gruppen aufweisen, die zu einer chemischen Reaktion befähigt sind. Die Reaktion wird beispielsweise um so selektiver, je mehr Aminogruppen der Ligand trägt, die nicht über das Zentralatom koordiniert sind, wie dies beispielsweise bei cis-η2-N,N-Bis-(2-aminoethyl)-aminodicyanoplatin(II) der Fall ist. Besonders geeignet sind Komplexe, bei denen das Metall bereits in der Oxidationsstufe 0 vorliegt, weil dadurch die Bildung von Keimen bzw. Clustern erheblich vereinfacht wird und vor allem an modifizierten Oberflächen erfolgt. Derartige Komplexe sind beispielsweise Triphosphinokomplexe von Palladium und Platin. Die Ligandensysteme derartiger Komplexe lassen sich sehr leicht modifizieren, beispielsweise durch Sulfonierung oder Aminierung. Beispiele für modifizierte Systeme sind 3-[His(3-sulfophenyl)-phosphino]-benzolsulfonsäure und 1,3,5-Triaza-7-phospho-tricyclo-[3.3.1.1]decan. Aufgrund der Modifizierung der Ligandensysteme diffundieren die Komplexe entweder in die belichteten oder in die unbelichteten Bereiche des Dielektrikums. Dort können sie sich - über eine salzartige Bindung - an funktionelle Gruppen des Dielektrikums anlagern oder sie reagieren mit dem Dielektrikum direkt.

Beim Verfahren nach der Erfindung sind ferner solche Metallkomplexe geeignet, die photosensitiv sind; dies sind insbesondere Edelmetall-Komplexe mit Alken-Liganden oder mit Liganden, die beim Belichten Reaktionen eingehen, wie dies bei η2-Bipyridyl-4,4'-diamino-η2-stilbenopalladium(II) der Fall ist. Derartige Komplexe reagieren beim Belichten selek-tiv mit den belichteten oder mit den unbelichteten Bereichen des Dielektrikums. Die Metallkomplexe können im übrigen allgemein mononuclear oder polynuclear aufgebaut sein. Polynucleare Komplexe, sogenannte Cluster, sind quasi bereits vorgebildete Metallkeime.

Als Lösemittel für die Keimlösung kommen Wasser oder organische Lösemittel sowie entsprechende Mischungen in Frage. Besonders geeignet sind folgende organische Lösemittel: Ethanol, Isopropanol, Aceton, Butanon, Cyclopentanon, Cyclohexanon, Tetrahydrofuran, _-Butyrolacton, N-Methylpyrrolidon, Essigsäureethylester, Essigsäurebutylester, Ethoxyethylacetat und Ethoxyethylpropionat. Die Keimlösung kann auch Tenside, und zwar in ionischer oder in nicht-ionischer Form, und Amine, wie Triethylamin und Tetramethylamoniumhydroxid, enthalten.

Anhand von Ausführungsbeispielen soll die Erfindung noch näher erläutert werden.

Zur Herstellung der metallisierten Dielektrika dienen bevorzugt photosensitive Vorstufen von hochtemperaturstabilen Polymeren, insbesondere von Polyimiden und Polybenzoxazolen; diese Vorstufen bzw. entsprechende Lösungen sind kommerziell erhältlich. Photosensitive Polyimid-Vorstufen sind beispielsweise negativ arbeitende Polyamidsäureester, und photosensitive Polybenzoxazol-Vorstufen sind beispielsweise positiv arbeitende Polyohydroxyamide, welche einen Zusatz eines Diazonaphthochinons aufweisen. Diese Polymer-Vorstufen sind beispielsweise löslich in N-Methylpyrrolidon, bilden beim Aufschleudern auf ein Substrat homogene Schichten und sind sensitiv für i-line- und g-line-Belichtung. Durch einen Temperprozeß werden die entsprechenden Polymere gebildet, d.h. Polyimide und Polybenzoxazole, die bis 400°C bzw. 450°C temperaturstabil sind. Die dabei erhaltenen Dielektrika sind resistent gegenüber sauren und neutralen Ätzlösungen.

### Beispiel 1

Eine handelsübliche Lösung einer photosensitiven Vorstufe eines Polyimids (PI) wird mittels einer Horizontalschleuder bei 3000 rpm auf ein Siliziumsubstrat aufgetragen (Schleuderzeit: 20 s); anschließend wird 4 min bei 100°C auf einer Heizplatte getrocknet. Der dabei erhaltene Film wird mit einer Kontaktbelichtungsanlage über eine Maske belichtet (Belichtungsdosis: 250 mJ/cm²); dabei vernetzt die PI-Vorstufe. Nachfolgend wird das Substrat 10 min in eine Palladiumkomplex-Lösung, bestehend aus 200 mg Bis(acetato)-bis-(triphenylphosphin)-palladium, gelöst in 950 ml Isopropanol und 50 ml deionisiertem Wasser, getaucht und danach mit Iso-propanol und deionisiertem Wasser gespült. Der Palladiumkomplex lagert sich nur an die nicht-vernetzten Bereiche des Polyimids an, d.h. an die unbelichteten Bereiche. Das Substrat wird 30 min bei 300°C auf einer Heizplatte unter Stickstoff getempert, und dann wird der Palladiumkomplex mit einer alkalischen Borhydrid-Lösung (1 g Natriumborhydrid und 5 g Natriumhydroxid, gelöst in 1000 ml Wasser) reduziert (RT, 2 min). Anschließend erfolgt - selektiv auf den bekeimten Bereichen - eine chemische Verkupferung durch 15minütiges Tauchen in ein handelsübliches chemisches Kupferbad; dabei wird eine homogene haftfeste Kupferschicht erhalten. Das Kupferbad ist beispielsweise eine metastabile Lösung mit folgenden Bestandteilen: Kupfersalz, Komplexbildner, wie Tetrakis(2-hydroxyethyl)-ethylendiamin oder Ethylendiamintetraessigsäure (EDTA), Reduktionsmittel, wie Formaldehyd, und Stabilisatoren.

### Beispiel 2

Es wird entsprechend Beispiel 1 vorgegangen, die Metallisierung erfolgt jedoch mit einem handelsüblichen chemischen Nickelbad. Das Nickelbad ist beispielsweise eine metastabile Lösung mit folgenden Bestandteilen: Nikkelsalz, Komplexbildner, wie Citrat oder Tartrat, und Reduktionsmittel, wie Natriumhypophosphit. Auch hierbei wird eine homogene haftfeste Metallschicht erhalten.

### Beispiel 3

Eine handelsübliche Lösung einer photosensitiven Vorstufe eines Polybenzoxazols (PBO) wird mittels einer Horizontalschleuder bei 3500 rpm auf ein Glassubstrat aufgetragen (Schleuderzeit: 20 s); anschließend wird getrocknet: 60 s bei 90°C und dann 120 s bei 120°C. Der dabei erhaltene Film wird mit einer Kontaktbelichtungsanlage über eine Maske belichtet (Belichtungsdosis: 300 mJ/cm²); durch die Belichtung werden im Film Carboxylgruppen generiert. Nachfolgend wird das Sub-strat 10 min in eine Palladiumkomplex-Lösung, bestehend aus 200 mg η2-Bipyridyl-4,4'-diamino-η2-stilbenoplatin(II), ge-löst in 1000 ml eines Isoprppanol/Wasser-Gemisches (Volumen-verhältnis 3:1), getaucht; dabei lagert sich der Palladiumkomplex an die Carboxylgruppen an. Somit werden nur die be-lichteten Bereiche des Films bekeimt. Das Substrat wird 3 min bei 250°C und 3 min bei 350°C auf einer Heizplatte unter Stickstoff getempert, und dann wird der Palladiumkomplex mit einer Hydrazin-Lösung (5 %ige Lösung in Wasser) reduziert (RT, 5 min). Anschließend werden die belichteten Bereiche in entsprechender Weise wie in Beispiel 1 metallisiert; dabei wird eine homogene haftfeste Kupferschicht erhalten.

Als Bekeimungslösung kann - unter sonst gleichen Bedingungen - auch folgende Lösung verwendet werden: 250 mg des Platinkomplexes cis-[ Pt4 (hp) 4 (NH3) 8(NO3)2] (NO3)-3·H2O, gelöst in 500 ml Wasser, dem 0, 5 ml 24 %ige Ammoniaklösung zugesetzt wurden; "hp" steht dabei für ein deprotoniertes 2-Hydroxypyridin. Es werden die gleichen Ergebnisse erhalten.

### Beispiel 4

Entsprechend Beispiel 3 wird eine Lösung einer photosensitiven PBO-Vorstufe auf ein Substrat aufgeschleudert, getrocknet und über eine Maske belichtet. Nachfolgend wird das Substrat bei 40°C 1 min in eine Quell-Lösung, bestehend aus Diethylenglykolmonoethylether und deionisiertem Wasser (Volumenverhältnis 1:1), getaucht; hierbei werden nur die belichteten Bereiche angequollen. Wird das Substrat anschließend bei Raumtemperatur 10 min in eine wäßrige Palladiumchlorid-Lösung (300 mg/l) getaucht, so lagern sich die Palladiumionen in die belichteten PBO-Bereiche ein. Nach der Reduktion des Palladiumsalzes (4 min) durch Tauchen in eine neutrale Natriumborhydrid-Lösung (2 g, gelöst in 1000 ml Wasser) wird das PBO bei 285°C 20 min auf einer Heizplatte unter Stickstoff getem-pert und anschließend analog Beispiel 2 metallisiert. Es wird eine homogene haftfeste Metallschicht erhalten.

### Beispiel 5

Entsprechend Beispiel 1 wird eine Lösung einer photosensitiven Polyimid-Vorstufe auf ein Substrat geschleudert und getrocknet. Anschließend wird das Substrat 10 min in eine Tetrakis(triphenylphoshin)-palladium(0)-Lösung, bestehend aus 150 mg Palladiumkomplex, gelöst in 1000 ml Toluol, getaucht, 1 min mit Toluol/Methanol (1:1) gespült und 2 min bei 100°C getrocknet. Danach erfolgt eine strukturierende Belichtung mit einer Kontaktbelichtungsanlage (Belichtungsdosis: 250 mJ/cm²). Nachfolgend wird das Substrat 2 min mit Toluol, 1 min mit Toluol/Methanol und 1 min mit Methanol gespült, bei 300°C getempert und dann entsprechend Beispiel 1 metallisiert. Dabei wird in den belichteten Bereichen eine homogene haftfeste Kupferschicht erhalten.

### Beispiel 6

Entsprechend Beispiel 1 wird eine Lösung einer photosensitiven Polyimid-Vorstufe auf ein Siliziumsubstrat (4 Zoll) aufgeschleudert und getrocknet. Anschließend werden auf das Substrat 10 ml einer ethanolischen Di-pchloro-tetraethylen-dirhodium(I)-Lösung (50 mg/l) gesprüht, und das Substrat wird dann 3 min bei 65°C getrocknet. Danach wird das Substrat mit einer Kontaktbelichtungsanlage über eine Maske belichtet (Belichtungsdosis: 200 mJ/cm²); in den belichteten Bereichen vernetzt dabei das Polyimid, und zudem zersetzt sich der Rhodiumkomplex. Anschließend wird das Polyimid 60 s mit einem handelsüblichen Polyimid-Entwickler (Hauptkomponenten: Butylacetat und γ-Butyrolacton) entwickelt, jeweils 60 s mit Butylacetat, Isopropanol, Isopropanol/deionisiertem Wasser (1:1) sowie deionisiertem Wasser gespült und 4 min bei 100°C getrocknet. Der Rhodiumkomplex wird dann durch Tauchen (10 min) in eine auf pH 8 eingestellte Ascorbinsäurelösung in Wasser/Ethanol (1:1) reduziert, und das Polyimid wird bei 325°C 40 min unter Stickstoff getempert und anschließend entsprechend Beispiel 2 metallisiert. Dabei wird eine homogene haftfeste Metallschicht erhalten.

### Beispiel 7

Entsprechend Beispiel 1 wird eine Lösung einer photosensitiven Polyimid-Vorstufe auf ein Substrat aufgeschleudert und getrocknet. Anschließend wird auf das Substrat eine Platinkomplex-Lösung, bestehend aus 200 mg η2-Bipyridyl-4,4'-diamino-η2-stilbenoplatin(II) und 6 g Polypropylenglykol, ge-löst in einer Mischung aus 200 ml γ-Butyrolacton, 200 ml Isopropanol und 5 ml Wasser, bei 2500 rpm aufgeschleudert (25 s) und der dabei erhaltene Film bei 110°C 4 min getrocknet. Nach einer strukturierenden Belichtung mit einer Kontaktbelichtungsanlage (Beliehtungsdosis: 350 mJ/cm²), bei der der Platinkomplex aktiviert und das Polyimid vernetzt wird, wird das Polyimid entsprechend Beispiel 6 entwickelt und anschließend bei 350°C 1 h getempert. Danach werden die belichteten Bereiche entsprechend Beispiel 1 metallisiert. Dabei wird eine homogene haftfeste Kupferschicht erhalten.

## Patentansprüche

1. Verfahren zur Metallisierung von Dielektrika,
**dadurch gekennzeichnet,**
**dass** auf ein Substrat ein photoempfindliches Dielektrikum aufgebracht wird, welches ein photostrukturierbares Polymer ist,
**dass** das photostrukturierbare Polymer entweder durch eine Maske belichtet, mit einem Metall bekeimt und einer Temperaturbehandlung unterworfen wird oder mit einem Metall bekeimt und durch eine Maske belichtet wird und überschüssiges Bekeimungsmaterial entfernt wird, und dass anschließend das photostrukturierbare Polymer chemisch metallisiert wird.

2. Verfahren nach Anspruch 1,
**dadurch gekennzeichnet,**
**dass** das photostrukturierbare Polymer in gelöster oder pastöser Form auf das Substrat aufgebracht und dann getrocknet wird.

3. Verfahren nach Anspruch 1 oder 2
**dadurch gekennzeichnet,**
**dass** das photostrukturierbare Polymer mit einer metallhaltigen Keimlösung oder -emulsion behandelt wird.

4. Verfahren nach einem der Ansprüche 1 bis 3,
**dadurch gekennzeichnet,**
**dass** das photostrukturierbare Polymer durch eine Maske mit engen Graben- und Lochstrukturen belichtet wird.

5. Verfahren nach einem oder mehreren der Ansprüche 1 bis 4,
**dadurch gekennzeichnet,**
**dass** das photostrukturierbare Polymer mittels einer Edelmetallverbindung bekeimt wird.

6. Verfahren nach einem oder mehreren der Ansprüche 1 bis 5,
**dadurch gekennzeichnet,**
**dass** das Bekeimungsmaterial ein Metall der Oxidationsstufe 0 enthält.

7. Verfahren nach einem oder mehreren der Ansprüche 1 bis 6,
**dadurch gekennzeichnet,**
**dass** das Bekeimungsmaterial einen photosensitiven Metallkomplex enthält.

## Claims

1. Method for metallizing dielectrics, **characterized in that**
a photosensitive dielectric which is a photostructurable polymer is applied to a substrate,
the photostructurable polymer is either exposed to light through a mask, seeded with a metal and subjected to a thermal treatment or seeded with a metal and exposed to light through a mask and excess seeding material is removed,
and the photostructurable polymer is then chemically metallized.

2. Method according to Claim 1, **characterized in that** the photostructurable polymer is applied in dissolved or pasty form to the substrate and then dried.

3. Method according to Claim 1 or 2, **characterized in that** the photostructurable polymer is treated with a metal-containing seed solution or emulsion.

4. Method according to any of Claims 1 to 3, **characterized in that** the photostructurable polymer is exposed to light through a mask having narrow valley and hole structures.

5. Method according to one or more of Claims 1 to 4, **characterized in that** the photostructurable polymer is seeded by means of a noble metal compound.

6. Method according to one or more of Claims 1 to 5, **characterized in that** the seeding material contains a metal of oxidation state 0.

7. Method according to one or more of Claims 1 to 6, **characterized in that** the seeding material contains a photosensitive metal complex.

## Revendications

1. Procédé de métallisation de diélectriques, **caractérisé**
**en ce que** l'on dépose sur un substrat un diélectrique photosensible qui est un polymère pouvant être photostructuré,
**en ce que** l'on expose le polymère photostructuré à travers un masque, on l'ensemence d'un métal et on le soumet à un traitement en température ou on l'ensemence avec un métal et on l'expose à travers un masque et on élimine de la matière d'ensemencement en excès et en ce qu'ensuite on métallise chimiquement le polymère pouvant être photostructuré.

2. Procédé suivant la revendication 1, **caractérisé**
**en ce que** l'on dépose le polymère pouvant être photostructuré sous forme dissoute ou pâteuse sur le substrat et ensuite on le sèche.

3. Procédé suivant la revendication 1 ou 2, **caractérisé**
**en ce que** l'on traite le polymère pouvant être photostructuré par une solution ou par une émulsion d'ensemencement contenant du métal.

4. Procédé suivant l'une des revendications 1 à 3, **caractérisé**
**en ce que** l'on expose le polymère pouvant être photostructuré à travers un masque ayant des structures en sillons et en trous qui sont étroites.

5. Procédé suivant l'une ou plusieurs des revendications 1⁻ à 4, **caractérisé**
**en ce que** l'on ensemence le polymère pouvant être photostructuré au moyen d'un composé de métal précieux.

6. Procédé suivant l'une ou plusieurs des revendications 1 à 5, **caractérisé**
**en ce que** le matériau d'ensemencement contient un métal du degré d'oxydation 0.

7. Procédé suivant l'une ou plusieurs des revendications 1 à 6, **caractérisé**
**en ce que** le matériau d'ensemencement contient un complexe métallique photosensible.
